# EUROPÄISCHE PATENTSCHRIFT

(11) **EP 1 759 456 B1**
(45) Veröffentlichungstag und Bekanntmachung des Hinweises auf die Patenterteilung: **15.04.2015**
(21) Anmeldenummer: 05742665.2
(22) Anmeldetag: 09.05.2005
(51) Int. Cl.: H03G 3/20, H04L 27/26

(54) **EMPFANGSSCHALTUNG UND VERFAHREN ZUM EMPFANGEN EINES OFDM-SIGNALS**
RECEIVE CIRCUIT AND METHOD FOR RECEIVING AN OFDM SIGNAL
CIRCUIT DE RECEPTION ET PROCEDE POUR RECEVOIR UN SIGNAL OFDM

(30) Priorität: 17.06.2004 DE 102004029372; 16.07.2004 DE 102004034382
(43) Veröffentlichungstag der Anmeldung: 07.03.2007
(73) Patentinhaber: ROBERT BOSCH GMBH, 70442 Stuttgart (DE)
(72) Erfinder: HOFMANN, Frank, 31139 Hildesheim (DE); SPREITZ, Gerald, 30880 Laatzen (DE); JAKOBLEW, Sascha, 31141 Hildesheim (DE); GRUN, Daniel, 31135 Hildesheim (DE)
(86) Internationale Anmeldenummer: PCT/EP2005/052086
(87) Internationale Veröffentlichungsnummer: WO 2005/125000

(56) Entgegenhaltungen:
- EP-A- 1 231 721
- US-A1- 2002 186 796
- US-A1- 2004 014 441
- US-B1- 6 591 092

## Beschreibung

Die Erfindung betrifft eine Empfangsschaltung zum Empfangen eines OFDM-Signals, insbesondere für den digitalen Rundfunk oder für drahtlose LAN-Netze. Die Erfindung betrifft weiterhin ein Verfahren zum Empfangen eines OFDM-Signals.

Eine AGC (Automatic Gain Control) ist bei einer Einpfangs-schaltung in Empfängern, die einen sehr hohen Dynamikbereich abdecken sollen, erforderlich. Mit Hilfe einer solchen Empfangsschaltung kann auf die schwankenden Empfangsfeldstärken und damit auf unterschiedliche Pegel am Empfängereingang reagiert werden.

Bei z.B. sehr geringen Pegeln ist eine gute Rauschzahl für die gesamte Empfangsschaltung wichtig, während'die Intermodulationseigenschaften eher von nebengeordneter Bedeutung sind. Bei sehr starken Pegeln sind dagegen die Intermodulationseigenschaften wichtig, während eine gute Rauschzahl unwichtiger ist. Darüber hinaus sollte die Empfangsschaltung zwischen den Stufen das Signal auf einen gewissen Regelbereich regeln, um die nachfolgende Stufe optimal ansteuern zu können.

In vielen Systemen werden diese Anforderungen mit Hilfe einer analogen AGC-Empfangsschaltung erreicht. Dabei erfolgt die Regelung der Verstärkung kontinuierlich. Nachteilig dabei ist es, dass sich bei schwankenden Pegeln die momentanen Verstärkungswerte nicht bestimmen lassen.

Bei einer Empfangsschaltung mit digitaler AGC sind die Verstärker als geschaltete Stufen realisiert, so dass bei einer Nachregelung des Verstärkungswerts der Verstärkungswert diskret, d. h. stufenweise, eingestellt wird. Bei Pegelveränderungen am Eingang wird dann die Verstärkung der einzelnen Stufen in geeigneter Weise eingestellt. Da die Verstärkungswerte zwischen den Verstärkungsstufen springen, führt dies in der Regel zu Störungen und aufgrund des Schaltvorgangs zu Signalunterbrechungen, so dass eine der Empfangsschaltung nachgeschaltete Signalauswerteeinheit die springenden Signalpegel falsch interpretiert.

Aus der US 6,591,092 B1 ist ein Signalempfangsgerät mit einer Verstärkungssteuerung und dessen Verfahren bekannt, wobei die Verstärkung eines Rundfunksignalempfängers für das DAB-System gesteuert wird, um ein Ausgangssignal eines vorherbestimmten Pegels zu erhalten, wobei eine AGC-Schleife verwendet wird. Das DAB-Signal umfasst ein Sicherheitsintervall innerhalb eines Intervalls eines jeden Symbols, und das Sicherheitsintervall enthält keine gültigen Daten, die wieder gewonnen werden sollen. Folglich wird die Verstärkungsänderung der AGC-Schleife innerhalb des Sicherheitsintervalls durchgeführt.

Es ist Aufgabe der vorliegenden Erfindung, eine Empfangsschaltung zum Empfangen eines OFDM-Signals zur Verfügung zu stellen, die eine digital einstellbare Verstärkereinheit aufweist, und wobei eine fehlerhafte Signalauswertung aufgrund eines durch den Wechsel des Verstärkungswertes springenden Zwischensignals vermieden wird.

Es ist weiterhin Aufgabe der vorliegenden Erfindung, ein Verfahren zum Empfangen eines OFDM-Signals zur Verfügung zu stellen, bei dem Signalunterbrechungen beim Auswerten des Zwischensignals nicht auftreten.

Diese Aufgabe wird durch die Empfangsschaltung nach Anspruch 1 sowie durch das Verfahren nach Anspruch 5 gelöst.

Weitere vorteilhafte Ausgestaltungen der Erfindung sind in den abhängigen Ansprüchen angegeben.

Gemäß einem ersten Aspekt der vorliegenden Erfindung ist eine Empfangsschaltung zum Empfangen eines OFDM-Signals vorgesehen. Das OFDM-Signal beinhaltet aufeinander folgende Rahmen mit einer Anzahl von OFDM-Symbolen, wobei die OFDM-Symbole sich aus einem Nutzintervall, das Nutzdaten beinhaltet, und einem Schutzintervall zusammensetzen, um die Nutzintervalle der OFDM-Symbole voneinander zu trennen. Es ist eine Eingangsschaltung zum Umsetzen der Frequenz des OFDM-Signals vorgesehen, um ein Zwischensignal zu erhalten. Mit Hilfe einer Auswerteeinheit werden aufeinander folgende Zeitfenster festgelegt und die OFDM-Symbole in den Zeitfenstern ausgewertet. Eine digital einstellbare Verstärkereinheit wird mit Hilfe einer Verstärkersteuerung so angesteuert, um die Verstärkung der Verstärkereinheit einzustellen, so dass die Signalstärke der Zwischensignale in einem vorbestimmten Signalstärkebereich liegt. Eine Steuereinheit ist mit der Verstärkersteuerung so verbunden, dass die Verstärkung der Verstärkereinheit während eines synchronen Betriebs zu einem oder mehreren Zeitpunkten außerhalb der Zeitfenster eingestellt wird. Weiter ist eine Initialisierungseinheit vorgesehen, um während einer Initialisierungsphase die Verstärkung der Verstärkereinheit zu einem oder mehreren Zeitpunkten unabhängig von den Zeitfenstern einzustellen. Die Auswerteeinheit ist dazu ausgebildet, für mindestens einen Rahmen ein Bezugssignal zum Festlegen der Zeitpunkte zu generieren. Die Steuereinheit weist eine Zeitsteuerung mit einem Zeitgeber auf, wobei die Zeitsteuerung dazu ausgebildet ist, die Zeitpunkte durch Hinzufügen von Vielfachen einer Symbollänge, die sich aus den Längen des Nutzintervalls und des Schutzintervalls zusammensetzt, zu dem Zeitpunkt des Bezugssignals zu bestimmen.

Die Empfangsschaltung gemäß der vorliegenden Erfindung hat einen Vorteil, da das Zwischensignal, das einer nachfolgenden Signalauswertung zur Verfügung gestellt wird, keine Pegelsprünge im Bereich der OFDM-Symbole aufgrund von Schaltvorgängen enthält, die die Nutzdaten beinhalten. Pegelsprünge treten außerhalb der Zeitfenster auf, so dass eine Signalunterbrechung bei dem Auswerten des Zwischensignals nicht auftreten kann. Dies ist beim Empfangen eines OFDM-Signals möglich, da die OFDM-Symbole in dem OFDM-Signal jeweils ein Nutzintervall und ein Schutzintervall umfasst, wobei Nutzdaten lediglich in dem Nutzintervall vorhanden sind. Das Schutzintervall stellt einen Zeitraum dar, in dem keine Nutzdaten enthalten sind, so dass die Nutzintervalle voneinander durch das Schutzintervall getrennt sind. Die Zeitfenster werden so über die Nutzintervalle gelegt, dass diese optimal ausgewertet werden können, wobei die Zeitfenster in der Regel kleiner sind als die Zeitdauer der OFDM-Symbole, so dass zwischen den Zeitfenstern Zeiträume bestehen, in denen kein OFDM-Symbol ausgewertet wird. Diese Zeiträume werden erfindungsgemäß dazu benutzt, die Verstärkung der Empfangsschaltung einzustellen, so dass bei eventuellen Pegelsprüngen des Zwischensignals keine Störung bei dem auszuwertenden Signal auftritt.

Um eine ausreichende Zeit für die Einstellung der Verstärkung zu gewährleisten, kann die Steuereinheit so gestaltet sein, um den Zeitpunkt so zu wählen, dass er unmittelbar nach dem Zeitfenster liegt.

Gemäß einer weiteren Ausführungsform der Erfindung generiert die Auswerteeinheit für mindestens einen Rahmen ein Bezugssignal zum Festlegen der Zeitpunkte, wobei die Verstärkungssteuereinheit weiterhin eine Zeitsteuerung mit einem Zeitgeber aufweist, um die Zeitpunkte gemäß einer Funktion abhängig von dem Zeitpunkt des Bezugssignals zu bestimmen. Insbesondere kann die Zeitsteuerung die Zeitpunkte durch Hinzufügen von Vielfachen der Symbollänge zu dem Zeitpunkt des Bezugssignals bestimmen.

Es ist zweckmäßig, dass das Bezugssignal durch das Ende eines Zustands eines von der Steuereinheit generierten Wartesignals bestimmt ist, wobei der Zustand des Wartesignals der Verstärkersteuerung ein Blockieren des Einstellen der Verstärkung der Verstärkereinheit angibt. Insbesondere kann der Zustand des Wartesignals während eines Rahmensynchronisationssymbols des OFDM-Signals generiert werden. Da das Rahmensynchronisationssymbol häufig ein Nullsymbol darstellt, wobei der Signalpegel während des Nullsymbols sehr gering oder gleich Null ist, muss der Verstärkereinheit mitgeteilt werden, dass keine Anpassung der Verstärkung erfolgen soll, da ansonsten die Verstärkung sehr hoch eingestellt werden würde, so dass nachfolgende OFDM-Symbole zunächst übersteuert würden, bis die Verstärkung erneut auf die gewünschten Pegel der OFDM-Symbole eingestellt wird. Das Wartesignal weist deshalb die Steuereinheit während des Rahmensynchronisationssymbols an, keine Verstärkung vorzunehmen. Ändert sich der Zustand des Wartesignals, wird angezeigt, dass in Kürze das Übertragen der OFDM-Symbole beginnt. Da die Zeitsteuerung der Verstärkungssteuereinheit die Abfolge der OFDM-Symbole kennt, kann die Verstärkungssteuereinheit bei Kenntnis des Zeitpunktes der Änderung des Zustandes des Wartesignals die nachfolgenden Zeitpunkte bestimmen, die zwischen zwei aufeinander folgenden Zeitfenstern liegen. Dabei ist es nicht notwendig, die Verstärkung in jeder Pause zwischen zwei Zeitfenstern erneut einzustellen. Die Funktion zur Bestimmung der Zeitpunkte ist im Wesentlichen frei wählbar, wobei es zweckmäßig ist, Zeitpunkte durch Hinzufügen von Vielfachen der Symbollänge zu dem Zeitpunkt des Bezugssignals zu bestimmen.

Gemäß einer weiteren Ausführungsform der Erfindung kann eine Initialisierungseinheit vorgesehen sein, um während einer Initialisierungsphase die Verstärkung der Verstärkereinheit zu einem oder mehreren Zeitpunkten unabhängig von den Zeitfenstern einzustellen. Die Initialisierungseinheit sorgt dafür, dass die Verstärkung so schnell wie möglich nach dem Beginn des Empfangens des OFDM-Signals auf den gewünschten Pegel eingestellt wird, so dass so schnell wie möglich das erhaltene Zwischensignal ausgewertet werden kann. Da es während der Initialisierungsphase nicht notwendig ist, ein unterbrechungsfreies Signal zu erhalten, sieht die Initialisierungseinheit vor, die Verstärkung während der Initialisierungsphase unabhängig von den Zeitfenstern einzustellen, um so schnell wie möglich die optimale Verstärkung für das OFDM-Signal zu erreichen.

Gemäß einem weiteren Aspekt der vorliegenden Erfindung ist ein Verfahren zum Empfangen eines OFDM-Signals vorgesehen, wobei das OFDM-Signal aufeinander folgende Rahmen mit einer Anzahl von OFDM-Symbolen beinhaltet. Die OFDM-Symbole setzen sich aus einem Nutzintervall, das Nutzdaten beinhaltet und einem Schutzintervall zusammen, um die Nutzintervalle der OFDM-Symbole voneinander zu trennen. Das Verfahren weist die Schritte des Umsetzens der Frequenz des OFDM-Signals, um ein Zwischensignal zu erhalten, des Festlegens von aufeinander folgenden Zeitfenstern, des Auswertens der OFDM-Symbole in den Zeitfenstern, des Einstellens der Verstärkung, so dass die Signalstärke der Zwischensignale in einem vorbestimmten Signalstärkebereich liegt, wobei die Verstärkung während eines synchronen Betriebs nur zu einem oder mehreren Zeitpunkten außerhalb der Zeitfenster eingestellt wird, wobei während einer Initialisierungsphase die Verstärkung zu einem oder mehreren Zeitpunkten unabhängig von den Zeitfenstern eingestellt wird, und des Generierens eines Bezugssignal zum Festlegen der Zeitpunkte für mindestens einen Rahmen, wobei die Zeitpunkte durch Hinzufügen von Vielfachen der Symbollänge zu dem Zeitpunkt des Bezugssignals bestimmt werden.

Vorzugsweise ist der Zeitpunkt so gewählt, dass er unmittelbar nach einem Ende eines der Zeitfenster liegt.

Es ist zweckmäßig, dass für mindestens einen Rahmen ein Bezugssignal zum Festlegen der Zeitpunkte generiert wird, wobei die Zeitpunkte gemäß einer Funktion abhängig von dem Zeitpunkt des Bezugssignals bestimmt werden. Insbesondere werden die Zeitpunkte durch Hinzufügen von Vielfachen der Symbollänge zwischen dem Zeitpunkt des Bezugssignals bestimmt.

Vorzugsweise kann das Bezugssignal durch das Ende eines Zustandes eines generierten Wartesignals bestimmt sein, wobei der Zustand des Wartesignals ein Blockieren des Einstellens der Verstärkung angibt. Der Zustand des Wartesignals wird während eines Rahmensynchronisationssymbols des OFDM-Signals generiert.

Vorzugsweise wird die Verstärkung während einer Initialisierungsphase zu einem oder mehreren Zeitpunkten eingestellt, die unabhängig von dem Zeitfenster sind.

Bevorzugte Ausführungsformen der Erfindung werden nachfolgend mit Bezug auf die beigefügten Zeichnungen näher erläutert. Es zeigen:
Fig. 1 ein Blockschaltbild eines digitalen OFMD-Empfängers;
Fig. 2 ein Blockschaltbild einer digitalen Empfangsschaltung für einen OFDM-Empfänger; und
Fig. 3 ein Zeitablaufdiagramm zur Darstellung der Steuerung der Verstärkungseinstellung.

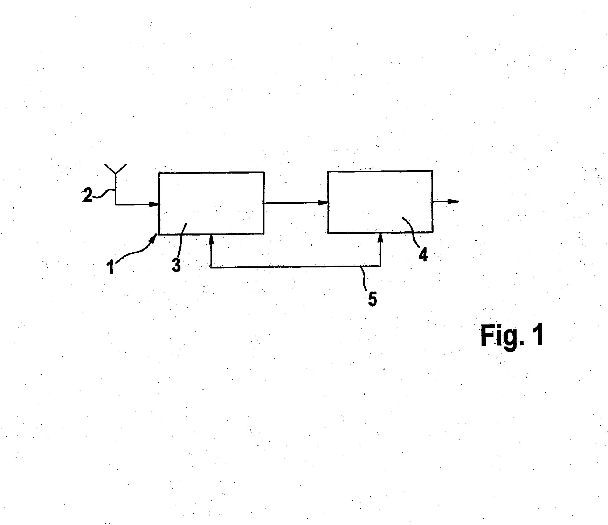

In Fig. 1 ist ein Blockschaltbild einer Empfangsschaltung 1 für OFDM-Signale beispielsweise für den digitalen Rundfunk dargestellt. Der gleiche Aufbau kann auch für einen WLAN-Empfänger verwendet werden, um OFDM-Signale für die Übertragung von Daten zu empfangen. Die Empfangsschaltung 1 weist eine Antenne 2 zum Empfangen von OFDM-Funksignalen auf, die mit einer Eingangsschaltung 3 verbunden ist. Die Eingangsschaltung 3 wandelt das empfangene hochfrequente OFDM-Funksignal über eine oder mehrere Mischerstufen in ein Zwischensignal, das als auszuwertendes Signal an eine Signalauswerteeinheit 4 weitergegeben wird, die die auszuwertenden Signale in Nutzsignale im Basisband wandelt.

Die Eingangsschaltung 3 und die Signalauswerteeinheit 4 stehen über eine Steuerleitung 5 miteinander in Verbindung, so dass die Signalauswerteeinheit 4 die Eingangsschaltung 3 steuern kann und gleichzeitig ist es möglich, dass die Empfangsschaltung 3 der Signalauswerteeinheit 4 Angaben z. B. über die Empfangssignalstärke sowie über die eingestellte Verstärkung übermittelt.

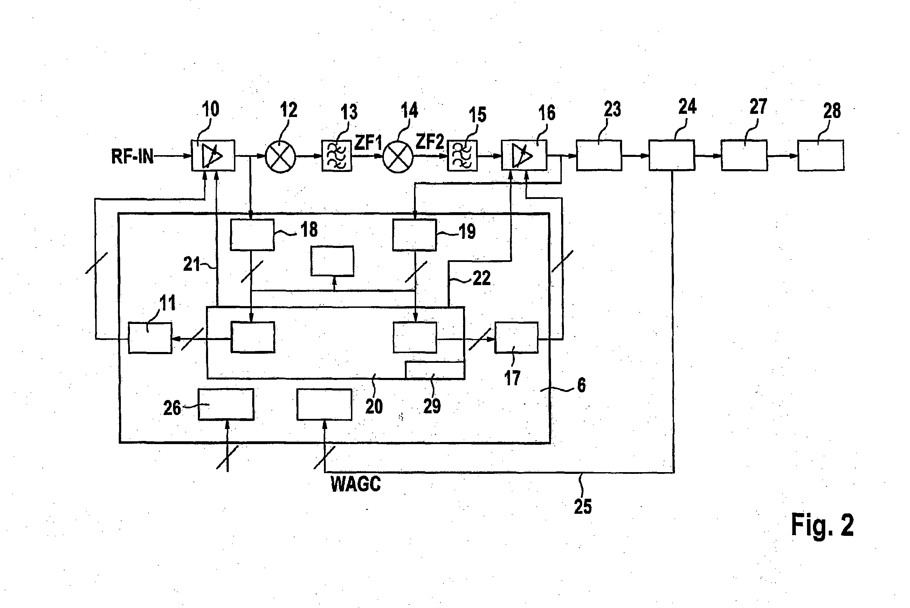

Die Eingangsschaltung 3 ist detailliert in Fig. 2 dargestellt. Die Eingangsschaltung 3 ist beispielsweise in klassischer Doppelheterodyn-Architektur aufgebaut. Das über die Antenne empfangene Funksignal RF-IN wird einer ersten Verstärkerstufe 10 zugeführt, die das OFDM-Funksignal RF-IN gemäß einer ersten Verstärkung, die durch einen in einem ersten Verstärkungsregister 11 gespeicherten ersten Verstärkungswert bestimmt ist. Anschließend wird die Frequenz des verstärkten OFDM-Funksignal RF-IN in einem ersten Mischer 12 umgesetzt und anschließend in einem ersten Filter 13 gefiltert, um ein gewünschtes erstes Zwischensignal ZF1 nach dem Mischen auszuwählen. Der Ausgang des ersten Filters 13 ist mit einem zweiten Mischer 14 verbunden, in dem die Frequenz des ersten Zwischensignals ZF1 erneut umgesetzt wird. Das umgesetzte erste Zwischensignal ZF1 wird in einem zweiten Filter 15 in geeigneter Weise gefiltert, um ein zweites Zwischensignal ZF2 auszuwählen und bereitzustellen. Das so erhaltene, gefilterte zweite Zwischensignal ZF2 wird in einer zweiten Verstärkerstufe 16 verstärkt. Die Verstärkung der zweiten Verstärkerstufe 16 wird durch einen zweiten Verstärkungswert, der in dem zweiten Verstärkungsregister 17 gespeichert ist, eingestellt. Am Ausgang der zweiten Verstärkungsstufe 16 liegt das zweite Zwischensignal ZF2 so an, dass sich seine Signalstärke in einem gewünschten Signalstärkenbereich befindet.

Um den ersten und zweiten Verstärkungswert zu bestimmen, werden die Signalstärken an den jeweiligen Ausgängen der ersten und zweiten Verstärkerstufe 10, 16 mit Hilfe eines ersten Pegeldetektors 18 bzw. eines zweiten Pegeldetektors 19 bestimmt. Beide Pegeldetektoren 18, 19 übermitteln die gemessenen Signalstärken an eine Verstärkungssteuereinheit 20, die den ersten und zweiten Verstärkungswert abhängig von den gemessenen Signalstärken und/oder abhängig von dem eingestellten ersten und zweiten Verstärkungswert bestimmt. Die Verstärkungssteuerung 20 übermittelt an das erste und zweite Verstärkungsregister 11, 17 den ersten bzw. den zweiten Verstärkungswert. Die Verstärkungssteuerung 20 ist so gestaltet, dass die optimalen Werte für den ersten und zweiten Verstärkungswert mit Hilfe geeigneter Algorithmen bestimmt werden.

Über eine erste Übernahmeleitung 21 und eine zweite Übernahmeleitung 22 ist die Verstärkungssteuerung 20 mit der ersten Verstärkerstufe 10 bzw. mit der zweiten Verstärkerstufe 16 verbunden. Über die erste bzw. zweite Übernahmeleitung wird mit Hilfe eines geeigneten Übernahmesignals die jeweilige Verstärkerstufe 10, 16 so angesteuert, dass das Übernahmesignal den Zeitpunkt angibt, zu dem die jeweilige Verstärkerstufe 10, 16 den ersten bzw. zweiten Verstärkungswert aus den Verstärkungsregistern 11, 17 entnimmt und die Verstärkung entsprechend dem jeweiligen Verstärkungswert einstellt. Da es sich bei den Verstärkungswerten um diskrete Werte handelt, kann es bei einer Änderung des jeweiligen Verstärkungswerts dazu kommen, dass die Signalstärke des zweiten Zwischensignals ZF2 am Ausgang der zweiten Verstärkungsstufe 16 springt, so dass eine Auswertung des zweiten Zwischensignals unterbrochen werden kann.

Das zweite Zwischensignal ZF2 am Ausgang der zweiten Verstärkerstufe 16 wird einem Analog-Digital-Wandler 23 zugeführt, wo das zweite Zwischensignal ZF2 digitalisiert wird und anschließend einer Auswerteeinheit 24 zugeführt wird, wo die OFDM-Symbole entsprechend eingestellten Zeitfenstern ausgewertet werden. Die Zeitfenster werden in optimaler Weise über die OFDM-Symbole gelegt, so dass diese zuverlässig ausgewertet werden können.

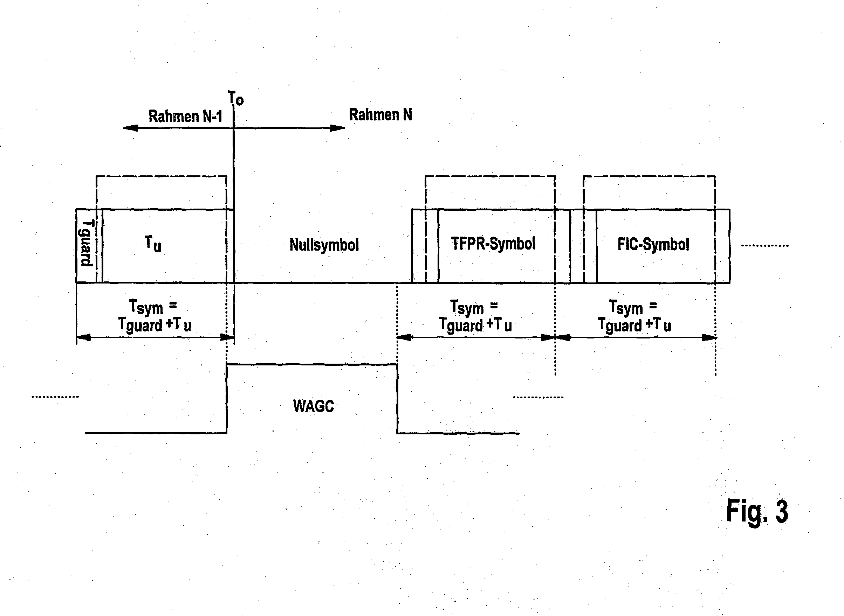

Das OFDM-Funksignal besteht aus Rahmen gleicher Zeitdauer mit jeweils mehreren OFDM-Symbolen. In Fig. 3 ist ein Ausschnitt eines Zeitbereichs beim Wechsel von einem Rahmen zum nächsten dargestellt, wobei ein Rahmen N zum Zeitpunkt TO beginnt. Als erstes Symbol wird ein so genanntes Nullsymbol übertragen, der ein so genanntes Rahmensynchronisationssymbol ist und dazu dient, grob den Rahmenanfang zu signalisieren (Grobsynchronisation). Anschließend wird ein weiteres Synchronisationssymbol, das so genannte TFPR-Symbol (Time, Frequency, Phase Reference Symbol) übertragen, das eine genauere Feststellung der zeitlichen Lage des Rahmens ermöglicht (Feinsynchronisation). Anschließend wird ein FIC-Symbol übermittelt, in dem eine Inhaltsinformationen von nachfolgenden Nutzsymbolen bereitgestellt wird. Nach dem FIC-Symbol folgt eine vorbestimmte Anzahl von Nutzsymbolen, die aus Gründen der Übersichtlichkeit der Darstellung nicht gezeigt sind.

Jedes Nutzsymbol umfasst ein Nutzintervall Tᵤ, in dem die Nutzdaten codiert sind, und ein Schutzintervall T_{guard}, das zur Trennung der OFDM-Symbole voneinander dient. Das Schutzintervall T_{guard} ist die periodische Wiederholung eines Teils des Nutzintervalls Tᵤ. Die Auswertung der Symbole im Empfänger erfolgt allgemein in einem Zeitfenster, welches die Länge des Nutzintervalls Tᵤ aufweist. Das Zeitfenster wird mit Hilfe der Zeitsynchronisation der Auswerteeinheit 24 zeitlich so gelegt, um Intersymbolinterferenz bei Auftreten von Echos (Mehrwegeausbreitung) zu verhindern.

Die Verstärkersteuerung ist so gestaltet, um die Übernahmesignale auf den Übernahmesignalleitungen 21, 22 für die erste bzw. zweite Verstärkerstufe 10, 16 zu Zeitpunkten zur Verfügung zu stellen, die zwischen den Zeitfenstern zum Auswerten der OFDM-Symbole liegen. Insbesondere ist vorteilhaft, wenn diese Zeitpunkte unmittelbar nach dem Ende eines solchen Zeitfensters liegt, um ausreichend Zeit für die Einstellung der Verstärkerstufen zur Verfügung zu haben.

Beispielsweise kann die Auswerteeinheit das Ende jeden Zeitfensters für jedes Symbol über die Steuerleitung 25 mit Hilfe eines geeigneten Signals mitteilen.

Diese Vorgehensweise ist jedoch recht aufwendig und da die Lage der Zeitfenster in einem Rahmen beim digitalen Rundfunk äquidistant ist, reicht in der Regel eine Information über die zeitliche Lage des ersten Zeitfensters für die Verstärkersteuerung 20 aus. Dazu wird ein bestimmtes Signal verwendet, welches von der Auswerteschaltung 24 zu Beginn des Rahmens generiert wird. Dieses Signal ist ein Wartesignal WAGC, das mit einem Zustand anzeigt, dass keine Verstärkung während des Vorliegens dieses Zustands des Wartesignals vorgenommen werden darf. Dieses Wartesignal WAGC liegt in der Regel während der Zeitdauer des Nullsymbols an bzw. endet kurz vor dem Ende des Nullsymbols und verhindert, dass die Verstärkung entsprechend der Signalstärke des OFDM-Funksignals während des Nullsymbols eingestellt wird. Ein Einstellen der Signalstärke des OFDM-Nullsymbols hätte nämlich zur Folge, dass die Verstärkung sehr hoch eingestellt würde, da die Signalstärke des OFDM-Funksignals während des Nullsymbols sehr gering ist. Das darauffolgende TFPR-Symbol würde dann mit derselben eingestellten Verstärkung gestärkt und damit stark übersteuert werden.

Der Zustand des Wartesignals WAGC, in dem keine Verstärkung stattfinden soll, wird durch den High-Pegel bestimmt. Die fallende Flanke des Wartesignals WAGC wird nun zeitlich so festgelegt, dass sie exakt eine Symbollänge T_{sym}, die sich aus dem Nutzintervall Tᵤ und dem Schutzinterval T_{guard} zusammensetzt, vor dem Ende des ersten Zeitfensters für das erste OFDM-Symbol nach dem Nullsymbol liegt. Da sich die Zeitfenster bei OFDM-Symbolen gleicher Länge mit einer festen Periodizität wiederholen, kann anhand der fallenden Flanke des Wartesignals WAGC der Zeitpunkt des Endes jeden Zeitfensters bestimmt werden, indem für den Zeitpunkt der fallenden Flanke des Wartesignals Vielfache der Symbollängen T_{sym} addiert werden. Eine Synchronisation dieses Ablaufs findet jeweils zu Beginn eines Rahmens mit dem Ende des Zustands des Wartesignals WAGC statt. Innerhalb eines Rahmens muss die Verstärkungssteuerung die Systemtakte zwischen den Symbolen mit einem geeigneten Zähler 29 selbst bestimmen. Beim nächsten Wartesignal wird der Zähler erneut für den nächsten Rahmen synchronisiert.

Diese Ablaufsteuerung ist in weiten Bereichen konfigurierbar. So können z.B. Auswertezeiten für die Algorithmen ebenso vorgegeben werden, wie die Häufigkeit der synchronen Schaltvorgänge. Bei Kenntnis der Längen der einzelnen OFDM-Symbole in einem Rahmen können auch unterschiedliche Zeitabstände zu dem Zeitpunkt der fallenden Flanke des Wartesignals hinzuaddiert werden, um die Zeitpunkte zwischen den Zeitfenstern zu bestimmen. Ebenso kann vorgesehen sein, dass nicht jeder Zeitraum zwischen zwei Zeitfenstern für das Einstellen der Verstärkung benutzt wird. Eine solche Einstellung der Auswertezeiten und Algorithmen zur Bestimmung der Zeitpunkte, zu denen die Verstärkung eingestellt werden soll, kann in einem Konfigurationsregister 26 eingestellt werden, das durch eine Steuereinheit (nicht gezeigt) beschrieben wird.

Zu Beginn des Verstärkungsvorgangs, z.B. nach dem Einschalten der Empfangsschaltung, sind die Verstärkungswerte in der Regel beliebig, so dass die Verstärkung nicht auf die Signalstärke des empfangenen OFDM-Funksignals eingestellt ist. Die Einstellung der Verstärkungen der Verstärkungsstufen 10, 16 erfolgt üblicherweise schrittweise, so dass eine größere Anzahl von Verstärkungsänderungen notwendig ist, um nach dem Einschalten die optimale Verstärkung des OFDM-Signals zu erhalten. Um nach dem Starten des Verstärkungsvorgangs die optimale Verstärkung so schnell wie möglich zu erreichen, ist während eines Initialisierungsmodus zulässig, die Einstellung der Verstärkungswerte auch während der Nutzsymbole vorzunehmen. Dies kann zu fehlerhaften Signalauswertungen führen, die jedoch aufgrund der fehlenden Synchronisation auf die Nutzsymbole hingenommen werden müssen. Nach dem Beenden des Initialisierungsmodus wird von diesem asynchronen Betrieb zur Einstellung der Verstärkung der Empfangsschaltung auf den synchronen Betrieb, der zuvor beschrieben worden ist, umgeschaltet.

Die Nutzdaten werden von der Auswerteinheit 24 an eine nachfolgende Signalverarbeitung weitergereicht. Die Signalverarbeitung dient im Wesentlichen dazu, die Nutzdaten in eine Klang- oder Bildausgabe umzuwandeln. Da die Länge der Nutzdaten, die von der Auswerteeinheit an die Signalverarbeitung weitergeleitet werden, sehr groß ist, erfolgt dies bei einer hohen Übertragungsgeschwindigkeit, d. h. bei hohen Frequenzen. Hohe Frequenzen bewirken ein Signalübersprechen und können Störungen in den empfindlichen HF-Eingangsstufen der Empfangsschaltung hervorrufen. Aus diesem Grund wird zwischen der Auswerteeinheit 24 und der nachfolgenden Signalverarbeitung ein FIFO-Speicher 27 angeordnet, der die in der Auswerteeinheit 24 erhaltenen Nutzdaten zwischenspeichert und an die nachfolgende Signalverarbeitungseinheit 28 weitergereicht. Das Weiterreichen der in dem FIFO-Speicher 27 gespeicherten Nutzdaten erfolgt dabei zwischen den Zeitfenstern, in denen die Auswerteeinheit 24 die OFDM-Symbole auswertet. Die Datenübertragung aus dem FIFO-Speicher 27 an die nachfolgende Signalverarbeitungseinheit 28 erfolgt so schnell, dass die während eines OFDM-Symbols erhaltenen Daten vollständig innerhalb des Zeitraums zwischen zwei aufeinanderfolgenden Zeitfenstern an die Signalverarbeitungseinheit 28 übertragen werden können. Die Nutzdaten werden von der Auswerteeinheit 24 an eine nachfolgende Signalverarbeitung weitergereicht. Dieser Zeitraum entspricht üblicherweise der Dauer des Schutzintervalls, somit wird erreicht, dass bei der Übertragung von digitalen Signalen auf Datenleitungen in den empfindlichen HF-Eingangsstufen hervorgerufenen Störungen durch Signalübersprechen während der Zeiträume der Übertragung von OFDM-Symbolen vermieden werden, so dass der Empfang der OFDM-Symbole in den Zeitfenstern möglichst ungestört ist.

Die Datenrate der Übertragung zwischen dem FIFO-Speicher 27 und der Signalverarbeitungseinheit 28 ist um vorzugsweise den Faktor höher, wie das Zeitverhältnis von Nutz- zu Schutzintervall Tᵤ/T_{guard} eines OFDM-Symbols überträgt. Bei digitalem Rundfunk ist dies ein Verhältnis von 4:1, so dass die Daten mit einer Rate von ca. 200 MBit/s an die Signalverarbeitung 28 übertragen werden, wenn die digitalen Daten von der Auswerteeinheit 24 mit einer Rate von 50 MBit/s geliefert werden.

## Patentansprüche

1. Empfangsschaltung (1) zum Empfangen eines OFDM-Signals,
wobei das OFDM-Signal aufeinander folgende Rahmen mit einer Anzahl von OFDM-Symbolen beinhaltet,
wobei die OFDM-Symbole sich aus einem Nutzintervall (Tᵤ), das Nutzdaten beinhaltet, und einem Schutzintervall (T_{guard}) zusammensetzen, um die Nutz-intervalle (Tᵤ) der OFDM-Symbole voneinander zu trennen,
mit einer Eingangsschaltung (3) zum Umsetzen der Frequenz des OFDM-Signals, um ein Zwischensignal zu erhalten, mit einer Auswerteeinheit (24) zum Festlegen von aufeinander folgenden Zeitfenstern und zum Auswerten der OFDM-Symbole in den Zeitfenstern,
mit einer digital einstellbaren Verstärkereinheit (10, 16), und
mit einer Verstärkersteuerung (6), um eine Verstärkung der Verstärkereinheit (10, 16) einzustellen, so dass die Signalstärke des Zwischensignals in einem vorbestimmten Signalstärke-Bereich liegt,
wobei eine Steuereinheit (20) mit der Verstärkersteuerung (6) so verbunden ist, dass die Verstärkung der Verstärkereinheit (10, 16) während eines synchronen Betriebs zu einem oder mehreren Zeitpunkten außerhalb der Zeitfenster eingestellt wird,
wobei eine Initialisierungseinheit vorgesehen ist, um während einer Initialisierungsphase die Verstärkung der Verstärkereinheit (10, 16) zu einem oder mehreren Zeitpunkten unabhängig von den Zeitfenstern einzustellen,
wobei die Auswerteeinheit (24) dazu ausgebildet ist, für mindestens einen Rahmen ein Bezugssignal zum Festlegen der Zeitpunkte zu generieren, und die Steuereinheit (20) eine Zeitsteuerung mit einem Zeitgeber (29) aufweist, wobei die Zeitsteuerung dazu ausgebildet ist, die Zeitpunkte durch Hinzufügen von Vielfachen einer Symbollänge (T_{sym}), die sich aus den Längen des Nutzintervalls (Tᵤ) und des Schutzintervalls (T_{guard}) zusammensetzt, zu dem Zeitpunkt des Bezugssignals zu bestimmen.

2. Empfangsschaltung (1) nach Anspruch 1, wobei die Empfangsschaltung dazu ausgebildet ist, das Bezugssignal durch das Ende eines Zustandes eines von der Auswerteeinheit (24) generierten Wartesignals (WAGC) zu bestimmen, wobei der Zustand des Wartesignals (WAGC) der Verstärkersteuerung (6) ein Blockieren des Einstellens der Verstärkung der Verstärkereinheit (10, 16) angibt.

3. Empfangsschaltung (1) nach Anspruch 2, wobei die Auswerteeinheit (24) dazu ausgebildet ist, den Zustand des Wartesignals (WAGC) während eines Rahmen-Synchronisationssymbols des OFDM-Signals zu generieren.

4. Empfangsschaltung (1) nach einem der Ansprüche 1 bis 3, wobei eine Signalverarbeitungseinheit (28) mit der Eingangsschaltung (5) verbunden ist, wobei die Steuereinheit (20) so gestaltet ist, um die Nutzdaten von der Eingangsschaltung nur außerhalb der Zeitfenster an die Signalverarbeitungseinheit (28) weiterzureichen.

5. Verfahren zum Empfangen eines OFDM-Signals,
wobei das OFDM-Signal aufeinander folgende Rahmen mit einer Anzahl von OFDM-Symbolen beinhaltet,
wobei die OFDM-Symbole sich aus einem Nutzintervall (Tᵤ), das Nutzdaten beinhaltet, und einem Schutzintervall (T_{guard}) zusammensetzen, um die Nutzintervalle (Tᵤ) der OFDM-Symbole voneinander zu trennen,
mit folgenden Schritten:
- Umsetzen der Frequenz des OFDM-Signals, um ein Zwischensignal zu erhalten,
- Festlegen von aufeinander folgenden Zeitfenstern;
- Auswerten der OFDM-Symbole in den Zeitfenstern;
- Einstellen einer Verstärkung, so dass die Signalstärke des Zwischensignals in einem vorbestimmten Signalstärke-Bereich liegt, wobei die Verstärkung während eines synchronen Betriebs nur zu einem oder mehreren Zeitpunkten außerhalb der Zeitfenster eingestellt wird, wobei während einer Initialisierungsphase die Verstärkung zu einem oder mehreren Zeitpunkten unabhängig von den Zeitfenstern eingestellt wird;
- Generieren eines Bezugssignal zum Festlegen der Zeitpunkte für mindestens einen Rahmen, wobei die Zeitpunkte durch Hinzufügen von Vielfachen der Symbollänge (T_{sym}) zu dem Zeitpunkt des Bezugssignals bestimmt werden.

6. Verfahren nach Anspruch 5, wobei das Bezugssignal durch das Ende eines Zustandes eines generierten Wartesignals (WAGC) bestimmt ist, wobei der Zustand des Wartesignals (WAGC) ein Blockieren des Einstellens der Verstärkung angibt.

7. Verfahren nach Anspruch 6, wobei der Zustand des Wartesignals während eines Rahmen-Synchronisationssymbols des OFDM-Signals generiert wird.

8. Verfahren nach einem der Ansprüche 5 bis 7, wobei die Nutzdaten zwischengespeichert werden und außerhalb der Zeitfenster übertragen werden.

## Claims

1. Reception circuit (1) for receiving an OFDM signal,
wherein the OFDM signal contains successive frames having a number of OFDM symbols,
wherein the OFDM symbols are compiled from a useful interval (Tᵤ), which contains useful data, and a guard interval (T_{guard}) in order to separate the useful intervals (Tᵤ) of the OFDM symbols from one another,
having an input circuit (3) for converting the frequency of the OFDM signal in order to obtain an intermediate signal, having an evaluation unit (24) for stipulating successive time windows and for evaluating the OFDM symbols in the time windows,
having a digitally adjustable amplifier unit (10, 16), and
having an amplifier controller (6) in order to adjust a gain of the amplifier unit (10, 16), so that the signal strength of the intermediate signal is in a predetermined signal strength range,
wherein a control unit (20) is connected to the amplifier controller (6) such that the gain of the amplifier unit (10, 16) is adjusted at one or more instants outside the time windows during synchronous operation,
wherein an initialization unit is provided in order to adjust the gain of the amplifier unit (10, 16) at one or more instants independently of the time windows during an initialization phase, wherein the evaluation unit (24) is designed to generate a reference signal for stipulating the instants for at least one frame,
and the control unit (20) has a time controller having a timer (29), wherein the time controller is designed to determine the instants by adding multiples of a symbol length (T_{sym}), which is compiled from the lengths of the useful interval (Tᵤ) and the guard interval (T_{guard}), to the instant of the reference signal.

2. Reception circuit (1) according to Claim 1, wherein the reception circuit is designed to determine the reference signal by means of the end of a state of a wait signal (WAGC) generated by the evaluation unit (24), wherein the state of the wait single (WAGC) indicates to the amplifier controller (6) that the adjustment of the gain of the amplifier unit (10, 16) is blocked.

3. Reception circuit (1) according to Claim 2, wherein the evaluation unit (24) is designed to generate the state of the wait signal (WAGC) during a frame synchronization symbol of the OFDM signal.

4. Reception circuit (1) according to one of Claims 1 to 3, wherein a signal processing unit (28) is connected to the input circuit (5), wherein the control unit (20) is configured so as to pass on the useful data from the input circuit to the signal processing unit (28) only outside the time windows.

5. Method for receiving an OFDM signal,
wherein the OFDM signal contains successive frames having a number of OFDM symbols,
wherein the OFDM symbols are compiled from a useful interval (Tᵤ), which contains useful data, and a guard interval (T_{guard}) in order to separate the useful intervals (Tᵤ) of the OFDM symbols from one another,
having the following steps:
- conversion of the frequency of the OFDM signal in order to obtain an intermediate signal;
- stipulation of successive time windows;
- evaluation of the OFDM symbols in the time windows;
- adjustment of a gain, so that the signal strength of the intermediate signal is in a predetermined signal strength range, wherein the gain is adjusted only at one or more instants outside the time windows during synchronous operation, wherein the gain is adjusted at one or more instants independently of the time windows during an initialization phase;
- generation of a reference signal for stipulating the instants for at least one frame, wherein the instants are determined by adding multiples of the symbol length (T_{sym}) to the instant of the reference signal.

6. Method according to Claim 5, wherein the reference signal is determined by means of the end of a state of a generated wait signal (WAGC), wherein the state of the wait signal (WAGC) indicates that the adjustment of the gain is blocked.

7. Method according to Claim 6, wherein the state of the wait signal is generated during a frame synchronization symbol of the OFDM signal.

8. Method according to one of Claims 5 to 7, wherein the useful data are buffer-stored and are transmitted outside the time windows.

## Revendications

1. Circuit de réception (1) destiné à recevoir un signal OFDM,
dans lequel le signal OFDM contient des trames se suivant les unes des autres comportant un certain nombre de symboles OFDM,
dans lequel les symboles OFDM se composent d'un intervalle utile (Tᵤ) qui contient des données utiles, et d'un intervalle de garde (T_{garde}) afin de séparer les uns des autres les intervalles utiles (Tᵤ) des symboles OFDM,
comportant un circuit d'entrée (3) pour convertir la fréquence du signal OFDM afin d'obtenir un signal intermédiaire, comportant une unité d'évaluation (24) pour établir des fenêtres temporelles se suivant les unes les autres et pour évaluer les symboles OFDM contenus dans les fenêtres temporelles,
comportant une unité d'amplification numérique réglable (10, 16), et
comportant une commande d'amplification (6) pour régler une amplification de l'unité d'amplification (10, 16) de manière à ce que l'intensité de signal du signal intermédiaire se situe dans un domaine prédéterminé d'intensité de signal,
dans lequel une unité de commande (20) comportant la commande d'amplification (6) est connectée de manière à ce que l'amplification de l'unité d'amplification (10, 16) soit réglée pendant un fonctionnement synchrone à un ou plusieurs instants se situant en dehors de la fenêtre temporelle,
dans lequel il est prévu une unité d'initialisation pour régler l'amplification de l'unité d'amplification (10, 16) pendant une phase d'initialisation à un ou plusieurs instants indépendamment des fenêtres temporelles,
dans lequel l'unité d'évaluation (24) est conçue pour générer un signal de référence, pour au moins une trame, afin d'établir les instants, et l'unité de commande (20) comprend une commande temporelle comportant une temporisation (29), dans lequel la commande temporelle est conçue pour déterminer les instants en ajoutant des multiples d'une longueur de symbole (T_{sym}) qui se compose des longueurs de l'intervalle utile (Tᵤ) et de l'intervalle de garde (T_{garde}) à l'instant du signal de référence.

2. Circuit de réception (1) selon la revendication 1, dans lequel le circuit de réception est conçu pour déterminer le signal de référence sur la base de la fin d'un état d'un signal d'attente (WAGC) généré par l'unité d'évaluation (24), dans lequel l'état du signal d'attente (WAGC) de la commande d'amplification (6) indique un blocage du réglage de l'amplification de l'unité d'amplification (10, 16).

3. Circuit de réception (1) selon la revendication 2, dans lequel l'unité d'évaluation (24) est conçue pour générer l'état du signal d'attente (WAGC) pendant un symbole de synchronisation de trames du signal OFDM.

4. Circuit de réception (1) selon l'une quelconque des revendications 1 à 3, dans lequel une unité de traitement du signal (28) est connectée au circuit d'entrée (5), dans lequel l'unité de commande (20) est conçue pour n'acheminer les données utiles du circuit d'entrée à l'unité de traitement du signal (28) qu'à l'extérieur de la fenêtre temporelle.

5. Procédé de réception d'un signal OFDM,
dans lequel le signal OFDM contient des trames se suivant les unes des autres comportant un certain nombre de symboles OFDM,
dans lequel les symboles OFDM se composent d'un intervalle utile (Tᵤ) qui contient des données utiles, et d'un intervalle de garde (T_{garde}) afin de séparer les uns des autres les intervalles utiles (Tᵤ) des symboles OFDM,
comprenant les étapes consistant à :
- convertir la fréquence du signal OFDM afin d'obtenir un signal intermédiaire,
- établir des fenêtres temporelles se suivant les unes les autres ;
- évaluer les symboles OFDM contenus dans les fenêtres temporelles ;
- régler une amplification de manière à ce que l'intensité de signal du signal intermédiaire se situe dans un domaine prédéterminé d'intensité de signal, dans lequel l'amplification effectuée pendant un fonctionnement synchrone n'est réglée qu'à un ou plusieurs instants se situant à l'extérieur de la fenêtre temporelle, dans lequel, pendant une phase d'initialisation, l'amplification est réglée à un ou plusieurs instants indépendamment des fenêtres temporelles ;
- générer un signal de référence pour établir les instants pour au moins une trame, dans lequel les instants sont déterminés par ajout de multiples des longueurs de symboles (T_{sym}) à l'instant du signal de référence.

6. Procédé selon la revendication 5, dans lequel le signal de référence est déterminé sur la base de la fin d'un état d'un signal d'attente (WAGC) généré, dans lequel l'état du signal d'attente (WAGC) indique un blocage du réglage de l'amplification.

7. Procédé selon la revendication 6, dans lequel l'état du signal d'attente est généré pendant un symbole de synchronisation de trames du signal OFDM.

8. Procédé selon l'une quelconque des revendications 5 à 7, dans lequel les données utiles sont stockées en mémoire tampon et sont transmises à l'extérieur de la fenêtre temporelle.
